# EUROPEAN PATENT SPECIFICATION

(11) **EP 2 615 649 B1**
(45) Date of publication and mention of the grant of the patent: **28.09.2022**
(21) Application number: 13150886.3
(22) Date of filing: 10.01.2013
(51) Int. Cl.: H01L 31/0735, H01L 31/0352, H01L 31/0304

(54) **Lateral solar cell structure**
Seitliche Solarzellenstruktur
Structure de cellule solaire latérale

(30) Priority: 10.01.2012 US 201213346982
(43) Date of publication of application: 17.07.2013
(73) Proprietor: The Boeing Company, Chicago, IL 60606-1596 (US)
(72) Inventor: Rehder, Eric M., Los Angeles, CA California 90041 (US)
(74) Representative: Howson, Richard Giles Bentham

(56) References cited:
- EP-A2- 1 923 918
- EP-A2- 2 339 643
- EP-A2- 2 343 731
- CN-A- 101 740 654
- US-A1- 2007 111 368
- US-A1- 2007 204 901
- US-A1- 2011 139 209
- ZHIYONG FAN ET AL: "Three-dimensional nanopillar-array photovoltaics on low-cost and flexible substrates", NATURE MATER, NATURE PUBLISHING GROUP, GB, vol. 8, 1 August 2009 (2009-08-01), pages 648-653, XP008144237, ISSN: 1476-1122, DOI: 10.1038/NMAT2493 [retrieved on 2009-07-05]
- SHIM M ET AL: "Anisotropic nanocrystal heterostructures: Synthesis and lattice strain", CURRENT OPINION IN SOLID STATE AND MATERIALS SCIENCE, ELSEVIER SCIENCE LTD, OXFORD, GB, vol. 14, no. 5, 1 October 2010 (2010-10-01), pages 83-94, XP027226617, ISSN: 1359-0286 [retrieved on 2010-05-12]
- Giacomo Mariani ET AL: "Patterned Radial GaAs Nanopillar Solar Cells", Nano Letters, vol. 11, no. 6, 8 June 2011 (2011-06-08), pages 2490-2494, XP055513852, US ISSN: 1530-6984, DOI: 10.1021/nl200965j

## Description

### BACKGROUND

The present disclosure relates to solar cells. In particular, it relates to lateral solar cell structures.

EP1 923 918 A2 discloses compositionally-graded hybrid nanostructure-based photovoltaic devices comprising elongated semiconductor nanostructures and an amorphous semiconductor single layer with continuous gradation of doping concentration across its thickness from substantially intrinsic to substantially conductive.

US 2011/0139209 A1 discloses a method of growing a thin film comprising growing a thin film by conformally forming at least one layer over a substrate having structures extending from a surface of the substrate, whereby the or each layer is formed over the surface of the substrate and over the structures extending from the surface.

US 2007/0111368 A1 discloses a photovoltaic structure and a method of forming a photovoltaic structure with a conductive nanowire array electrode. The method comprises: Forming a bottom electrode with conductive nanowires; forming a first semiconductor layer of a first dopant type overlying the nanowires; forming a second semiconductor layer of a second dopant type, overlying the first semiconductor layer; and forming a top electrode overlying the second semiconductor layer.

Zhiyong Fan et al: "Three-dimensional nanopillar-array photovoltaics on low-cost and flexible substrates", NATURE MATERIALS, vol. 8, August 2009, p. 648-653 in accordance with its abstract states "Solar energy represents one of the most abundant and yet least harvested sources of renewable energy. In recent years, tremendous progress has been made in developing photovoltaics that can be potentially mass deployed. Of particular interest to cost-effective solar cells is to use novel device structures and materials processing for enabling acceptable efficiencies. In this regard, here, we report the direct growth of highly regular, single-crystalline nanopillar arrays of optically active semiconductors on aluminium substrates that are then configured as solar-cell modules. As an example, we demonstrate a photovoltaic structure that incorporates three-dimensional, single-crystalline n-CdS nanopillars, embedded in polycrystalline thin films of p-CdTe, to enable high absorption of light and efficient collection of the carriers. Through experiments and modelling, we demonstrate the potency of this approach for enabling highly versatile solar modules on both rigid and flexible substrates with enhanced carrier collection efficiency arising from the geometric configuration of the nanopillars".

EP 2 339 643 A2 in accordance with its abstract states "A photovoltaic (PV) cell (200) is disclosed. The PV cell comprises, a plurality of ultrafine structures (202) electrically coupled to, and embedded within, a polycrystalline photo-active absorber layer (204) comprising a p-type compound semiconductor".

US 2007/0204901 A1 in accordance with its abstract states "Novel structures of photovoltaic cells (also treated as solar cells) are provided. The cells are based on nanometer-scaled wires, tubes, and/or rods, which are made of electronic materials covering semiconductors, insulators or metallic in structure. These photovoltaic cells have large power generation capability per unit physical area over the conventional cells. These cells will have enormous applications in space, commercial, residential, and industrial applications".

Shim M et al: "Anisotropic nanocrystal heterostructures: Synthesis and lattice strain", CURRENT OPINION IN SOLID STATE AND MATERIALS SCIENCE vol. 14, no. 5, October 2010, p. 83-94, in accordance with its abstract states "Emerging multi-component hybrid nanocrystalline materials are prompting new approaches to engineering materials' properties with nanoscale precision and providing complex systems with multiple functionalities. In particular, chemical synthesis of nanocrystal heterostructures where two or more distinct phases are brought together epitaxially in an anisotropic manner is providing novel materials with unique combinations of optical, electronic, magnetic, and chemical properties. However, in order to develop high quality materials with property combinations that can be precisely tailored, a better understanding of growth/formation mechanism(s) that will allow versatile and scalable synthetic approaches to be developed is necessary. Here, we review recent advances in anisotropic nanocrystal heterostructures with a special focus on how lattice strain arising from the heterointerfaces affects materials synthesis".

CN 101740654 A in accordance with its abstract states "A semiconductor pin junction solar cell epitaxial wafer based on InGaN nanopillars, comprising: a substrate for epitaxial growth of InGaN material thereon; and an InGaN material template for epitaxial growth of the InGaN material template on the substrate; a nanopillar array formed on the InGaN material template; a semiconductor solar cell pin structure, the pin structure epitaxially grown on the sidewall, top of the nanopillar array and the material between the nanopillar template surface. Also a preparation method of the semiconductor p-i-n junction solar cell epitaxial wafer based on the InGaN nano column."

G. Mariani et al, "Patterned Radial GaAs Nanopillar Solar Cells", Nano Letters, vol. 11, no. 6, 8 June 2011 p. 2490-2494, discloses photovoltaic devices using GaAs nanopillar radial p-n junctions.

EP 2343731 A2 in an abstract states that "In accordance with an embodiment, a diode comprises a substrate, a dielectric material including an opening that exposes a portion of the substrate, the opening having an aspect ratio of at least 1, a bottom diode material including a lower region disposed at least partly in the opening and an upper region extending above the opening, the bottom diode material comprising a semiconductor material that is lattice mismatched to the substrate, a top diode material proximate the upper region of the bottom diode material, and an active diode region between the top and bottom diode materials, the active diode region including a surface extending away from the top surface of the substrate."

### SUMMARY

The present invention is set out in the independent claims, with some optional features set out in the claims dependent thereto.

The present disclosure relates to a method, system, and apparatus for a lateral solar cell structure. According to a first aspect of the invention, there is provided a photovoltaic cell as defined in claim 1. According to a second aspect of the invention, there is provided a method of making a photovoltaic cell, the photovoltaic cell as defined in claim 12.

According to one or more aspects of the present disclosure there is provided a photovoltaic cell that includes an absorber region, and an emitter region comprising a plurality of nanorods extending into the absorber region. In some aspects, the absorber region and the nanorods are oppositely doped. In at least one aspect, the nanorods are n-type and the absorber region is p-type. In some aspects, the nanorods are p-type and the absorber region is n-type. In one or more aspects, the absorber region and the nanorods are formed of Group III-V alloys. In at least one aspect, the absorber region is formed of gallium arsenide nitride (GaAsN), indium gallium arsenide nitride (InGaAsN), aluminum indium phosphide (AlInP), or aluminum indium gallium phosphide (AlInGaP). In some aspects, the nanorods are formed of indium arsenide (InAs), indium gallium arsenide (InGaAs), gallium arsenide antimonide (GaAsSb), indium phosphide (InP), or indium gallium phosphide (InGaP).

In at least one aspect, the photovoltaic cell has a bandgap greater than 2.0 electron volts (eV). In some aspects, the photovoltaic cell has a bandgap less than 1.4 eV.

In one or more aspects, the spacing between each of the nanorods is less than three (3) microns. In at least one aspect, the diameter of each of the nanorods is between five (5) nanometers (nm) and 100 nm. In some aspects, the total area of the nanorods is less than one percent (1%) of the total area of the absorber region.

In at least one aspect, the nanorods and the absorber region are oppositely strained. In some aspects, the nanorods are tensile strained, and the absorber region is compressively strained. In one or more aspects, the nanorods are compressively strained, and the absorber region is tensile strained. In some aspects, the absorber region has an absorption length of between one half (0.5) and three (3) microns. In at least one aspect, the length of the nanorods is between fifty percent (50%) and one hundred percent (100%) of the absorption length.

In one or more aspects, a method of making a photovoltaic cell involves providing a substrate. The method further involves epitaxially growing an absorber region and an emitter region on the substrate. In at least one aspect, the emitter region comprises a plurality of nanorods extending into the absorber region. In some aspects, the absorber region and the nanorods are oppositely doped.

In at least one aspect, the nanorods and the absorber region are oppositely strained. In some aspects, the absorber region has an absorption length of between one half (0.5) and three (3) microns. In one or more aspects, the length of the nanorods is between 50% and 100% of the absorption length. In one or more aspects, the spacing between each of the nanorods is less than three (3) microns. In some aspects, the diameter of each of the nanorods is between five (5) nm and 100 nm. In at least one aspect, the total area of the nanorods is less than one percent (1%) of the total area of the absorber region. The features, functions, and advantages can be achieved independently in various embodiments of the present invention or the aspects may be combined in yet other embodiments.

### DRAWINGS

These and other features, aspects, and advantages of the present disclosure will become better understood with regard to the following description, appended claims, and accompanying drawings where:
FIG. 1 is a schematic diagram of a subcell having optimal bandgap properties and low efficiency.
FIG. 2 is a schematic diagram of a subcell having optimal bandgap properties and high efficiency, in accordance with at least one aspect of the present disclosure.
FIGS. 3A and 3B are schematic diagrams of exemplary of subcells having optimal bandgap properties and high efficiency, in accordance with embodiments of the present disclosure.
FIG. 4 is a graph illustrating the areal nanorod coverage for various combinations of nanorod diameter, and nanorod spacing, in accordance with at least one aspectof the present disclosure.
FIG. 4A is a top plan view of a subcell made in accordance with at least one aspectof the present disclosure.
FIG. 5 is a flow diagram of a method for making the subcells illustrated in FIGS. 2, 3A, 3B, and 4A, in accordance with at least one aspect of the present disclosure.

### DESCRIPTION

The methods and apparatus disclosed herein provide an operative system for a lateral solar cell structure. Specifically, this system includes multijunction solar cells including highly efficient subcells having optimal bandgap combinations. This system employs nanorods that are formed during the epitaxial growth process to produce electrodes extending into the absorber region of the solar cell. This design allows for a long optical absorption length of the absorber, such as 0.5 - 3 microns, but also allows for carrier collection over sub-micron distances matching the diffusion length.

Currently, the addition of N and Al to form alloys can produce desirable bandgaps, but the material quality tends to degrade resulting in short minority carrier diffusion lengths and low efficiencies. For example, the direct growth of cells made of materials such as InGaAsN and AlInGaP have been investigated. However, due to the low carrier diffusion length of these materials, cells formed of these materials are not highly efficient.

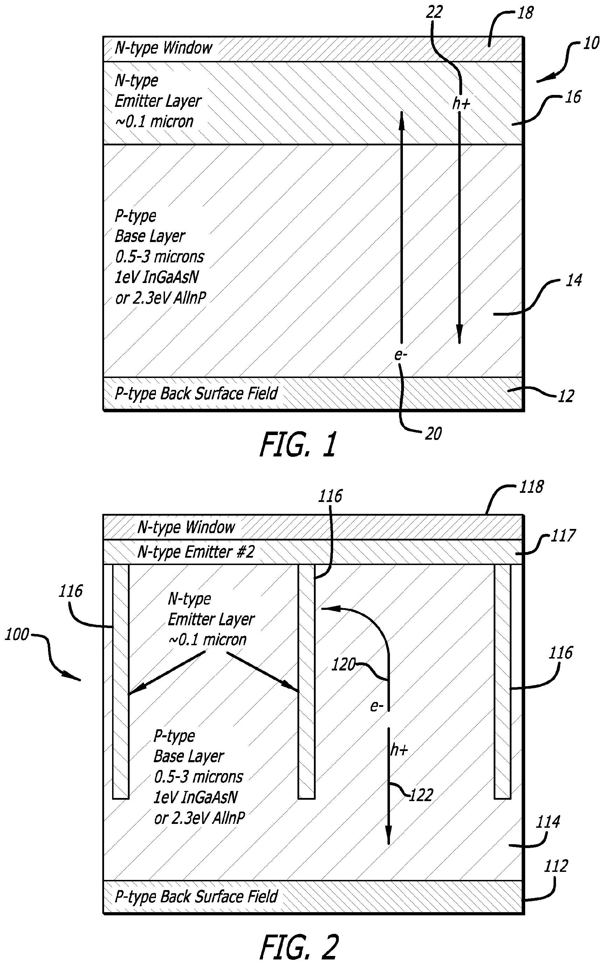

For example, FIG. 1 depicts a subcell component 10 formed by the direct growth approach. The subcell component 10 includes a p-type back surface field 12, a p-type base layer 14, an n-type emitter layer 16, and an n-type window 18. The base layer 14 may be formed of InGaAsN or AlInP. For high efficiency operation, electrons 20 created in the base layer 14 need to be able to cross the 0.5 - 3 micron thick base layer 14 to reach the emitter layer 16. Conversely, holes 22 created in the emitter layer 16 need to be able to cross the depletion region and reach the base layer 14. However, the sub-micron minority carrier length of InGaAsN and AlInP prevents this from occurring efficiently.

Another approach to forming cells having optimal bandgap properties is to utilize relaxed, metamorphic buffer layers. Many buffer layers are possible using the III-V alloys. A common approach to forming a 1 eV bandgap cell is to deposit a buffer layer consisting of InGaP alloys. The resulting cell is formed by InGaAs alloy having a 1 eV bandgap. However, the metamorphic buffer process is complex, making manufacturing difficult. In addition, the metamorphic buffer process results in increased film roughness and threading dislocation density, which reduces efficiency. The metamorphic buffer process also requires a very thick buffer layer, which is costly and reduces throughput.

Still another approach to forming cells having optimal bandgap properties is to utilize wafer bonding to integrate cells on GaAs and InP substrates. This approach requires two substrates and two growth processes forming cells on each substrate separately. Wafer bonding is used to attach these cells mechanically and electrically. At least one of the substrates is then removed to form the multijunction cell. Thus, the wafer bonding approach involves considerable expense required to have two film deposition processes, in addition to wafer bonding and substrate removal.

The disclosed system design allows for the fabrication of highly efficient subcells having optimal bandgap properties. By forming conducting nanorods imbedded in an absorber region of opposite conductivity type, the distance that the carriers have to travel is reduced, thereby increasing efficiency. In this manner, the disclosed system provides cells having higher efficiencies than those produced by the direct growth, metamorphic buffer, or wafer bonding approaches discussed above.

In the following description, numerous details are set forth in order to provide a more thorough description of the system. It will be apparent, however, to one skilled in the art, that the disclosed system may be practiced without these specific details. In the other instances, well known features have not been described in detail so as not to unnecessarily obscure the system.

FIG. 2 depicts a subcell component 100 of a multijunction solar cell in accordance with the proposed design. The subcell component 100 includes a back surface field 112, an absorber region 114, an emitter region 116, a window 118, and optionally an additional emitter layer (Emitter #2) 117. The emitter region 116 is formed of a plurality of nanorods 116 extending into the absorber region 114. The absorber region 114 and the nanorods 116 are formed of Group III-V alloys. For example, the absorber region 114 may be formed of GaAsP, GaAsN, InGaAsN, AlInP, or AlInGaP. The nanorods 116 may be formed of InAs, InGaAs, GaAsSb, InP, or InGaP. These materials provide optimal bandgap ranges. For example, if a N alloy (e.g., GaAsN, InGaAsN) is used to form the absorber region 114, then the absorber region 114 will have a bandgap of less than 1.4 eV, e.g., in the range of 1.0 to 1.4 eV. If an Al alloy (e.g., AlInP, or AlInGaP) is used to form the absorber region 114, then the absorber region 114 will have a bandgap greater than 2.0 eV, e.g., in the range of 2.0 to 2.3 eV.

The absorber region 114 may have an absorption length of between 0.5 and 3 microns. The, length of the nanorods 116 is at least about half of the absorption length. For example, the length of the nanorods 116 may be between 50% and 100% of the absorption length.

The nanorods 116 and the absorber region 114 have opposite conductivities, thereby forming a PN junction. For example, the nanorods 116 may be n-type, and the absorber region 114 may be p-type. Alternatively, the nanorods 116 may be p-type and the absorber region 114 may be n-type.

As discussed in greater detail below, the nanorods 116 and the absorber region 114 are oppositely strained. For example, the nanorods 116 may be compressively strained, and the absorber region 114 may be tensile strained. Alternatively, the nanorods 116 may be tensile strained, and the absorber region 114 may be compressively strained.

The structure shown in FIG. 2 separates the path of the photons and charge carriers. The photon absorption length remains long at 0.5 - 3 microns, yet the carriers will have a submicron distance for collection. For example, as depicted in FIG. 2, an electron 120 created in the absorber region 114 is able to travel to the closest nanorod 116, rather than having to cross substantially the entire thickness of the absorber region in order to reach the emitter layer.

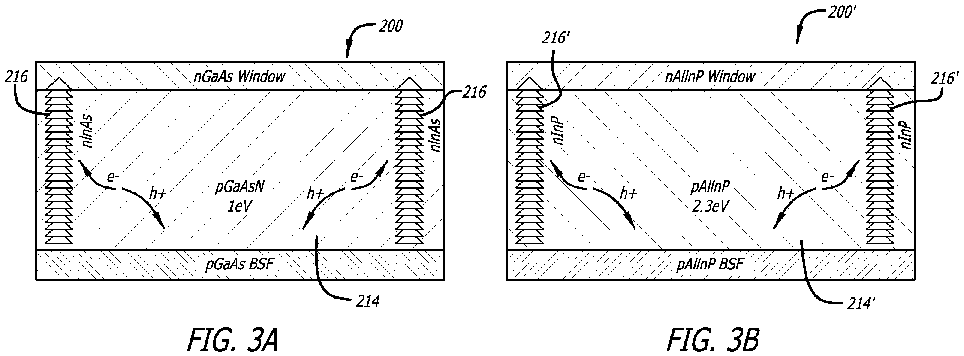

FIGS. 3A and 3B depict exemplary embodiments of subcells formed in accordance with the presently disclosed system. FIG. 3A depicts a cell 200 for 1.0 eV absorption having a p-type GaAsN absorber region 214 with n-type InAs nanorods 216. Alternatively, the cell 200 may have a p-type InGaAsN absorber region 214 and n-type InGaAs or GaAsSb nanorods 216. FIG. 3B shows a cell 200' for 2.3 eV absorption having a p-type AlInP absorber region 214' and n-type InP nanorods 216'. Alternatively, the 2.3eV bandgap cell 200' may have a p-type AlInGaP absorber region 214' and n-type InGaP nanorods 216'.

Thick material having highly strained nanorods will form strain relieving crystallographic defects that will reduce solar cell efficiency. However, by utilizing a strain compensation approach, the presently disclosed system avoids such defects. That is, by balancing the strain of the nanorods with an absorber region of opposite strain (tensile vs. compressive), crystalline defects may be prevented. The examples shown in FIGS. 3A and 3B show tensile strained, p-type absorber regions 214, 214'. The nanorods 216, 216' in these examples are compressively strained, n-type nanorods 216, 216'. These conductivity and strain properties may be inverted without changing the key elements of the system. For example, the nanorods 216, 216' may be p-type and the absorber regions 214, 214' may be n-type. The nanorods 216, 216' may be tensile and the absorber regions 214, 214' may be compressive.

The collection efficiency for light absorption in the nanorods may be low. Thus, ensuring a low fractional coverage of the nanorods is desirable for maximizing cell efficiency. That is, the ratio of the total area of the nanorods to the total area of the absorber region should be minimized. In one embodiment, the total area of the nanorods is less than 1% of the total area of the absorber region.

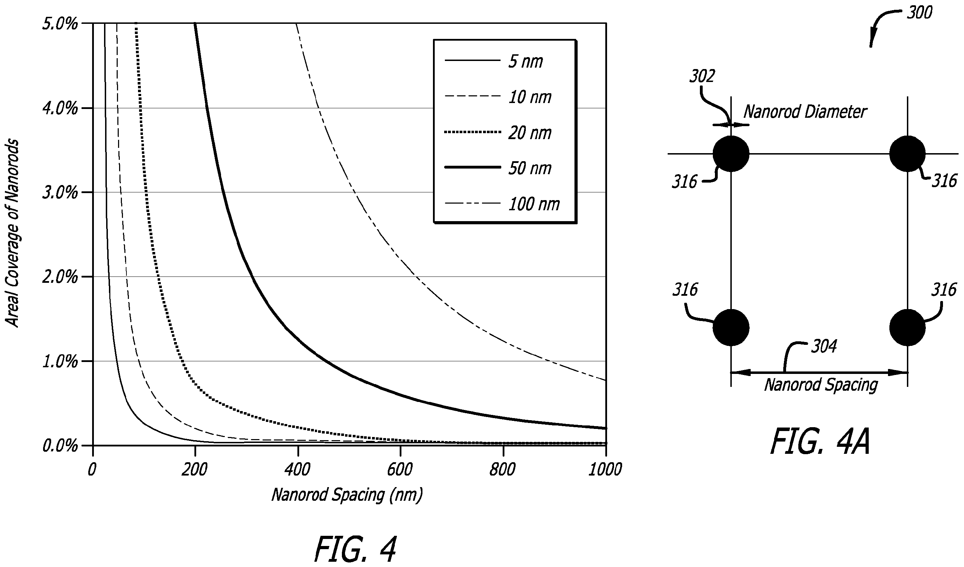

FIG. 4A is a top-down view of a cell 300 formed in accordance with the presently disclosed system. FIG. 4A depicts the diameter 302 of each nanorod 316. FIG. 4A also depicts the spacing 304 between each nanorod 316. The nanorod diameter 302 and spacing 304 may be controlled by the growth conditions used. The diameter 302 may controllably be varied between 5 and 100 nm and the spacing 304 between nanorods 316 may controllably be varied up to 3 microns. This combination will allow the coverage of nanorods to remain below 1% as shown in FIG. 4. The graph in FIG. 4 shows that, for a particular desired cell efficiency, by maintaining the coverage of the nanorods below 1%, and by controlling the nanorod diameters to be in the range of 5 to 100 nm, nanorod spacing of less than 3 microns may be used. A structure using nanorods 20 nm in diameter and a spacing of 200 nm will have < 1 % coverage of the nanorods. This structure will yield an electron path length (120) of < 100 nm, while allowing for an optically thick base layer of 0.5 to 3 microns. Therefore, high efficiency subcells can be formed from materials with low minority carrier diffusion lengths, such as InGaAsN or AllnP.

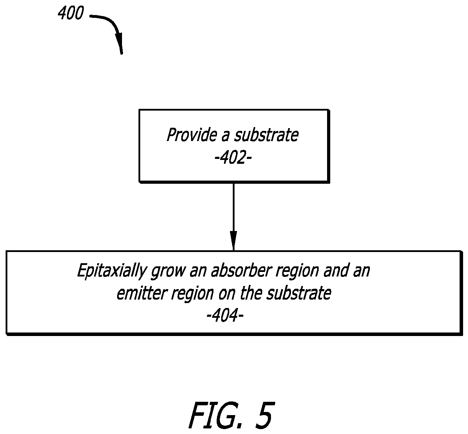

A method 400 of making a photovoltaic cell in accordance with the presently disclosed system is depicted in FIG. 5. The method includes a step 402 providing a substrate, and a step 404 of epitaxially growing an absorber region and an emitter region on the substrate. As discussed above, the emitter region comprises a plurality of nanorods extending into the absorber region, and the absorber region and the nanorods are oppositely doped. During the epitaxial growth, the nanorods are formed through strain driven self-organized clustering. Islands are closely stacked on top of each other to merge into a single, vertical nanorod. The strain of the nanorods is balanced by an oppositely strained absorber region.

Although certain illustrative embodiments and methods have been disclosed herein, it can be apparent from the foregoing disclosure to those skilled in the art that variations and modifications of such embodiments and methods can be made without departing from the scope of the appended claims.

## Claims

1. A photovoltaic cell comprising:
an absorber region (114); and
an emitter region (116,117) comprising a plurality of nanorods extending into the absorber region (114); wherein:
the absorber region (114) and the nanorods (116) are oppositely doped thereby forming a PN junction;
the absorber region (114) and the nanorods (116) are formed of Group III-V alloys; and
the nanorods (116) and the absorber region (114) are oppositely strained wherein:
the nanorods (116) are tensile strained and the absorber region (114) is compressively strained; or
the nanorods (116) are compressively strained and the absorber region (114) is tensile strained.

2. The photovoltaic cell of claim 1, wherein the nanorods (116) are n-type and the absorber region (114) is p-type.

3. The photovoltaic cell of claim 1, wherein the nanorods (116) are p-type and the absorber region (114) is n-type.

4. The photovoltaic cell of claim 1, wherein the absorber region (114) is formed of one of GaAsN, InGaAsN, AlInP, and AlInGaP.

5. The photovoltaic device of claim 1, wherein the nanorods (116) are formed of one of InAs, InGaAs, GaAsSb, InP, and InGaP.

6. The photovoltaic cell of claim 1 having a bandgap greater than 2.0 eV.

7. The photovoltaic cell of claim 1 having a bandgap less than 1.4 eV.

8. The photovoltaic cell of claim 1, wherein a spacing between each of the nanorods (116) is less than 3 microns.

9. The photovoltaic cell of claim 1, wherein a diameter of each of the nanorods (116) is between 5 nm and 100 nm.

10. The photovoltaic cell of claim 1, wherein a total area of the nanorods (116) is less than 1% of the total area of the absorber region (114).

11. The photovoltaic cell of claim 1, wherein the absorber region (114) has an absorption length of between 0.5 and 3 microns, and wherein a length of the nanorods (116) is between 50% and 100% of the absorption length of the absorber region (114)

12. A method of making a photovoltaic cell comprising:
providing a substrate; and
epitaxially growing an absorber region (114) and an emitter region (116) on the substrate; wherein:
the emitter region (116,117) comprises a plurality of nanorods (116) extending into the absorber region (114); the absorber region (114) and the nanorods (116) are oppositely doped thereby forming a PN junction;
the absorber region (114) and the nanorods (116) are formed of Group III-V alloys; and
the nanorods (116) and the absorber region (114) are oppositely strained wherein:
the nanorods (116) are tensile strained and the absorber region (114) is compressively strained; or
the nanorods (116) are compressively strained and the absorber region (114) is tensile strained.

13. The method of claim 12, wherein the absorber region (114) has an absorption length of between 0.5 and 3 microns, and/or wherein a length of the nanorods (116) is between 50% and 100% of the absorption length.

14. The method of claim 12, wherein a spacing between each of the nanorods is (116) is less than 3 microns, and/or wherein a diameter of each of the nanorods (116) is between 5nm and 100nm.

15. The method of claim 12, wherein a total area of the nanorods (116) is less than 1% of the total area of the absorber region (114).

## Patentansprüche

1. Photovoltaikzelle, die aufweist:
einen Absorberbereich (114); und
einen Emitterbereich (116, 117), der eine Vielzahl von Nanostäbchen aufweist, die sich in den Absorberbereich (114) erstrecken; wobei:
der Absorberbereich (114) und die Nanostäbchen (116) entgegengesetzt dotiert sind und dadurch einen PN-Übergang bilden;
der Absorberbereich (114) und die Nanostäbchen (116) aus Legierungen der Gruppe III-V gebildet sind; und
die Nanostäbchen (116) und der Absorberbereich (114) entgegengesetzt belastet sind, wobei:
die Nanostäbchen (116) zugbelastet sind und der Absorberbereich (114) druckbelastet ist; oder
die Nanostäbchen (116) druckbelastet sind und der Absorberbereich (114) zugbelastet ist.

2. Photovoltaikzelle nach Anspruch 1, wobei die Nanostäbchen (116) vom n-Typ sind und der Absorberbereich (114) vom p-Typ ist.

3. Photovoltaikzelle nach Anspruch 1, wobei die Nanostäbchen (116) vom p-Typ sind und der Absorberbereich (114) vom n-Typ ist.

4. Photovoltaikzelle nach Anspruch 1, wobei der Absorberbereich (114) aus einem von GaAsN, InGaAsN, AlInP und AlInGap gebildet ist.

5. Photovoltaikvorrichtung nach Anspruch 1, wobei die Nanostäbchen (116) aus einem von InAs, InGaAs, GaAsSb, InP und InGaP gebildet sind.

6. Photovoltaikzelle nach Anspruch 1, die eine Bandlücke größer als 2,0 eV hat.

7. Photovoltaikzelle nach Anspruch 1, die eine Bandlücke kleiner als 1,4 eV hat.

8. Photovoltaikzelle nach Anspruch 1, wobei ein Abstand zwischen jedem der Nanostäbchen (116) weniger als 3 Mikrometer beträgt.

9. Photovoltaikzelle nach Anspruch 1, wobei ein Durchmesser jedes der Nanostäbchen (116) zwischen 5 nm und 100 nm liegt.

10. Photovoltaikzelle nach Anspruch 1, wobei ein Gesamtbereich der Nanostäbchen (116) weniger als 1% des Gesamtbereichs des Absorberbereichs (114) ausmacht.

11. Photovoltaikzelle nach Anspruch 1, wobei der Absorberbereich (114) eine Absorptionslänge zwischen 0,5 und 3 Mikrometern hat, und wobei eine Länge der Nanostäbchen (116) zwischen 50% und 100% der Absorptionslänge des Absorberbereichs (114) beträgt.

12. Verfahren zum Herstellen einer Photovoltaikzelle, das aufweist:
Bereitstellen eines Substrats; und
epitaxiales Aufwachsenlassen eines Absorberbereichs (114) und eines Emitterbereichs (116) auf dem Substrat; wobei:
der Emitterbereich (116, 117) eine Vielzahl von Nanostäbchen (116) aufweist, die sich in den Absorberbereich (114) erstrecken;
der Absorberbereich (114) und die Nanostäbchen (116) entgegengesetzt dotiert sind und dadurch einen PN-Übergang bilden;
der Absorberbereich (114) und die Nanostäbchen (116) aus Legierungen der Gruppe III-V gebildet sind; und
die Nanostäbchen (116) und der Absorberbereich (114) entgegengesetzt belastet sind, wobei:
die Nanostäbchen (116) zugbelastet sind und der Absorberbereich (114) druckbelastet ist; oder
die Nanostäbchen (116) druckbelastet sind und der Absorberbereich (114) zugbelastet ist.

13. Verfahren nach Anspruch 12, wobei der Absorberbereich (114) eine Absorptionslänge zwischen 0,5 und 3 Mikrometern hat, und/oder wobei eine Länge der Nanostäbchen (116) zwischen 50% und 100% der Absorptionslänge beträgt.

14. Verfahren nach Anspruch 12, wobei ein Abstand zwischen jedem der Nanostäbchen (116) weniger als 3 Mikrometer beträgt und/oder wobei ein Durchmesser jedes der Nanostäbchen (116) zwischen 5 nm und 100 nm liegt.

15. Verfahren nach Anspruch 12, wobei ein Gesamtbereich der Nanostäbchen (116) weniger als 1% des Gesamtbereichs des Absorberbereichs (114) ausmacht.

## Revendications

1. Cellule photovoltaïque comprenant :
une région absorbante (114) ; et
une région émettrice (116, 117) comprenant une pluralité de nanotiges s'étendant dans la région absorbante (114) ; cellule photovoltaïque dans laquelle :
la région absorbante (114) et les nanotiges (116) sont dopées de manière opposée, formant ainsi une jonction PN ;
la région absorbante (114) et les nanotiges (116) sont formées d'alliages des Groupes III-V ; et
les nanotiges (116) et la région absorbante (114) sont contraintes de manière opposée, cellule photovoltaïque dans laquelle :
les nanotiges (116) sont contraintes en traction et
la région absorbante (114) est contrainte en compression ; ou bien
les nanotiges (116) sont contraintes en compression et la région absorbante (114) est contrainte en traction.

2. Cellule photovoltaïque selon la revendication 1, dans laquelle les nanotiges (116) sont du type n et la région absorbante (114) est du type p.

3. Cellule photovoltaïque selon la revendication 1, dans laquelle les nanotiges (116) sont du type p et la région absorbante (114) est du type n.

4. Cellule photovoltaïque selon la revendication 1, dans laquelle la région absorbante (114) est formée d'un des alliages tels que GaAsN, InGaAsN, AlInP et AlInGaP.

5. Dispositif photovoltaïque selon la revendication 1, dans lequel les nanotiges (116) sont formées d'un des alliages tels que InAs, InGaAs, GaAsSb, InP et InGaP.

6. Cellule photovoltaïque selon la revendication 1, ayant une bande interdite supérieure à 2,0 eV.

7. Cellule photovoltaïque selon la revendication 1, ayant une bande interdite inférieure à 1,4 eV.

8. Cellule photovoltaïque selon la revendication 1, dans laquelle un espacement entre chacune des nanotiges (116) est inférieur à 3 microns.

9. Cellule photovoltaïque selon la revendication 1, dans laquelle un diamètre de chacune des nanotiges (116) est compris entre 5 nm et 100 nm.

10. Cellule photovoltaïque selon la revendication 1, dans laquelle une surface totale des nanotiges (116) est inférieure à 1 % de la surface totale de la région absorbante (114).

11. Cellule photovoltaïque selon la revendication 1, dans laquelle la région absorbante (114) a une longueur d'absorption comprise entre 0,5 et 3 microns, et cellule photovoltaïque dans laquelle une longueur des nanotiges (116) est comprise entre 50 % et 100 % de la longueur d'absorption de la région absorbante (114).

12. Procédé de fabrication d'une cellule photovoltaïque, ledit procédé comprenant :
le fait de fournir un substrat ; et
le fait de faire croître par épitaxie, sur le substrat, une région absorbante (114) et une région émettrice (116) ; procédé dans lequel :
la région émettrice (116, 117) comprend une pluralité de nanotiges (116) s'étendant dans la région absorbante (114) ; la région absorbante (114) et les nanotiges (116) sont dopées de manière opposée,
formant ainsi une jonction PN ;
la région absorbante (114) et les nanotiges (116) sont formées d'alliages des Groupes III-V ; et
les nanotiges (116) et la région absorbante (114) sont contraintes de manière opposée, procédé dans lequel :
les nanotiges (116) sont contraintes en traction et
la région absorbante (114) est contrainte en compression ; ou bien
les nanotiges (116) sont contraintes en compression et la région absorbante (114) est contrainte en traction.

13. Procédé selon la revendication 12, dans lequel la région absorbante (114) a une longueur d'absorption comprise entre 0,5 et 3 microns, et/ou procédé dans lequel une longueur des nanotiges (116) est comprise entre 50 % et 100 % de la longueur d'absorption.

14. Procédé selon la revendication 12, dans lequel un espacement entre chacune des nanotiges (116) est inférieur à 3 microns, et/ou procédé dans lequel un diamètre de chacune des nanotiges (116) est compris entre 5 nm et 100 nm.

15. Procédé selon la revendication 12, dans lequel une surface totale des nanotiges (116) est inférieure à 1 % de la surface totale de la région absorbante (114).
